(19) Europäisches Patentamt
European Patent Office
Office européen des brevets

(11) **EP 1 611 615 B1**

(12) **EUROPÄISCHE PATENTSCHRIFT**

(45) Veröffentlichungstag und Bekanntmachung des Hinweises auf die Patenterteilung:
**31.08.2011 Patentblatt 2011/35**

(51) Int Cl.:
*H01L 29/732* (2006.01)    *H01L 29/737* (2006.01)
*H01L 21/331* (2006.01)    *H01L 29/06* (2006.01)

(21) Anmeldenummer: **04726497.3**

(22) Anmeldetag: **08.04.2004**

(86) Internationale Anmeldenummer:
**PCT/EP2004/003805**

(87) Internationale Veröffentlichungsnummer:
**WO 2004/090988 (21.10.2004 Gazette 2004/43)**

(54) **VERFAHREN ZUR HERSTELLUNG EINES BIPOLAREN HALBLEITERBAUELEMENTS, INSBESONDERE EINES BIPOLARTRANSISTORS, UND ENTSPRECHENDES BIPOLARES HALBLEITERBAUELEMENT**

METHOD FOR THE PRODUCTION OF A BIPOLAR SEMICONDUCTOR ELEMENT, ESPECIALLY A BIPOLAR TRANSISTOR, AND CORRESPONDING BIPOLAR SEMICONDUCTOR COMPONENT

PROCEDE DE PRODUCTION D'UN COMPOSANT A SEMI-CONDUCTEUR BIPOLAIRE, EN PARTICULIER D'UN TRANSISTOR BIPOLAIRE, ET COMPOSANT A SEMI-CONDUCTEUR BIPOLAIRE CORRESPONDANT

(84) Benannte Vertragsstaaten:
**DE FR GB**

(30) Priorität: **10.04.2003 DE 10316529**

(43) Veröffentlichungstag der Anmeldung:
**04.01.2006 Patentblatt 2006/01**

(73) Patentinhaber: **Infineon Technologies AG
85579 Neubiberg (DE)**

(72) Erfinder:
• **BOECK, Josef
81827 München (DE)**
• **MEISTER, Thomas
82024 Taufkirchen (DE)**
• **STENGL, Reinhard
86391 Stadtbergen (DE)**
• **SCHAEFER, Herbert
85635 Höhenkirchen-Siegertsbrunn (DE)**

(74) Vertreter: **Barth, Stephan Manuel
Reinhard, Skuhra, Weise & Partner GbR
Patent- und Rechtsanwälte
Friedrichstrasse 31
80801 München (DE)**

(56) Entgegenhaltungen:
**DE-A- 19 748 523    US-A1- 2001 022 381
US-A1- 2001 053 584    US-B2- 6 498 382**

• **MEISTER T F ET AL: "SiGe base bipolar technology with 74 GHz fmax and 11 ps gate delay" ELECTRON DEVICES MEETING, 1995., INTERNATIONAL WASHINGTON, DC, USA 10-13 DEC. 1995, NEW YORK, NY, USA,IEEE, US, 10. Dezember 1995 (1995-12-10), Seiten 739-742, XP010161097 ISBN: 0-7803-2700-4 in der Anmeldung erwähnt**

**Beschreibung**

Die vorliegende Erfindung betrifft ein Verfahren zur Herstellung eines bipolaren Halbleiterbauelements, insbesondere eines Bipolartransistors, und ein entsprechendes bipolares Halbleiterbauelement.

Um die Anschlussbereiche von Emitter und Basis in Bipolartransistoren voneinander elektrisch zu isolieren, stehen prinzipiell zwei Methoden zur Verfügung: Zum einen können die Anschlussbereiche mit Hilfe von Fotolithografie für die Emitter- und Basisbereiche definiert und mit Hilfe von Ätztechnik strukturiert werden. Man nennt solche Transistoren daher justierte Transistoren. Der Abstand zwischen Emitter und Basisanschluss ist dann durch die minimal verfügbare Lithografiebreite gegeben. Da mit lithografischen Verfahren nur Auflösungen von bis zu 0.1 μm erreicht werden können, ist dieses Verfahren nicht für skalierte Bipolartransistoren geeignet, bei denen der Emitter nur einige 0.1 μm breit ist und der Isolationsbereich zwischen Emitter und Basis noch deutlich kleiner sein sollte (typisch einige 10 nm). Zudem tritt bei einer Justierung von Emitter- zu Basisebene immer eine Unsymmetrie im Stromfluss auf, da aufgrund der Justiertoleranz von Emitter- zu Basisebene eine Seite des Emitters immer näher zum Basisanschlussgebiet liegt als die gegenüberliegende. Justierte Transistoren sind daher für moderne skalierte Höchstperformance- Transistoren ungeeignet.

Fast alle derzeitigen Transistoren werden daher als durch ein Emitterfenster selbstjustierte Transistoren ausgeführt. Die Emitter- und Basisanschlussbereiche werden dabei durch Polysiliziumschichten gebildet, die durch ein Dielektrikum (Siliziumoxid oder Siliziumnitrid) voneinander getrennt sind, weshalb sie auch als DPSA(selbstjustierte Doppel-Polysilizium)-Transistoren bezeichnet werden.

Das Dielektrikum wird als "Spacer" ausgebildet, d. h. durch anisotropes Rückätzen einer ganzflächig abgeschiedenen Schicht erzeugt, so dass im Emitterfenster die Spacer als Ätzresiduen übrig bleiben. Die Spacerbreite wird dabei durch die Dicke der Spacerschicht bestimmt und kann daher deutlich kleiner sein als Strukturen, die durch lithografische Verfahren erzeugt werden (im Prinzip nur wenige nm, typisch sind heute einige 10 nm). Daher ist dieses Verfahren zur Herstellung extrem skalierter DPSA-Transistoren geeignet.

Der DPSA-Transistor kann sowohl eine implantierte Si-Basis als auch eine epitaktisch abgeschiedene SiGe-Basis enthalten. Der Kollektor ist üblicherweise über eine im Substrat vergrabene Buried Layer (auch als Subkollektor bezeichnet) angeschlossen. Aufgrund ihrer lateralen und vertikalen Skalierbarkeit und den geringen parasitären Kapazitäts- und Widerstandsanteilen ist die DPSA-Transistorstruktur für Höchstgeschwindigkeitsanwendungen am besten geeignet.

DPSA-Transistoren und entsprechende Herstellungsverfahren sind z.B. aus US 2001/0053 584 oder aus T.F. Meister et al., IEDM Technical Digest 1995, p.739-741 oder aus T.H. Ning et al., Self-Aligned Bipolar Transistor for High-Performance and Low-Power-Delay VLSI, IEEE Transactions on Electron Devices, Vol. ED-28, No.9, pp. 1010-1013, 1981 oder aus der DE 199 58 062 C2 bekannt.

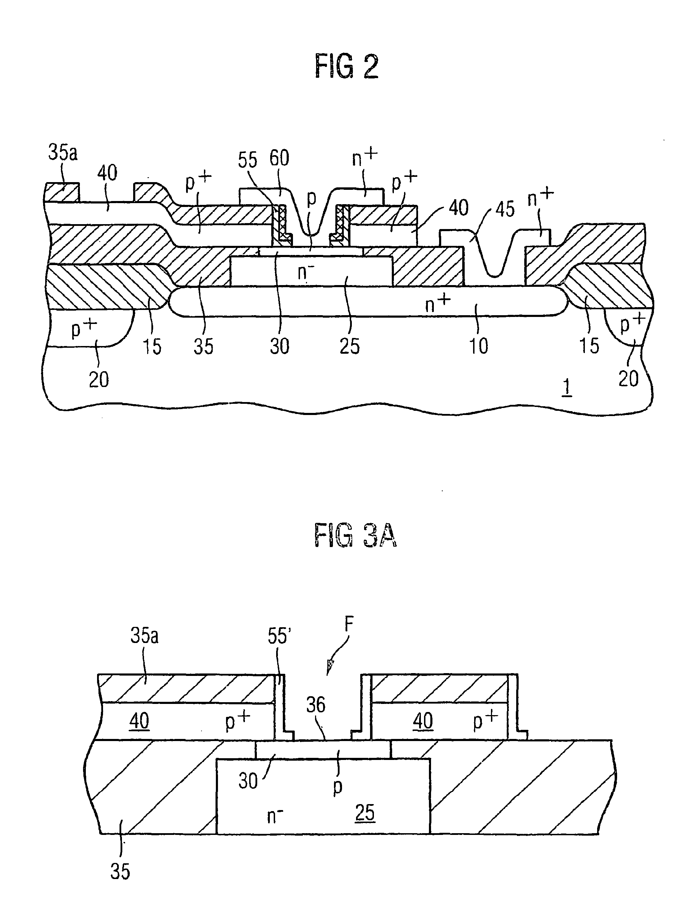

Fig. 2 ist eine schematische Darstellung eines bekannten DPSA-Transistors, wie aus T.F. Meister et al., IEDM Technical Digest 1995, p.739-741 bekannt.

In Fig. 2 bezeichnet Bezugszeichen 1 ein Silizium-Halbleitersubstrat, 10 einen $n^+$-Subkollektorbereich in Form einer vergrabenen Schicht, 20 $p^+$-Kanalsperrbereiche, 25 einen $n^-$-Kollektorbereich, 30 einen p-Basisbereich, 35 und 35a eine jeweilige CVD-Isolationsoxidschicht, 15 eine LOCOS-Isolationsoxidschicht, 40 einen $p^+$-Basisanschluss, 45 einen $n^+$-Kollektorkontakt, 55 einen Doppel-Spacer aus Siliziumoxid/Siliziumnitrid, und 60 einen $n^+$-Emitterkontakt.

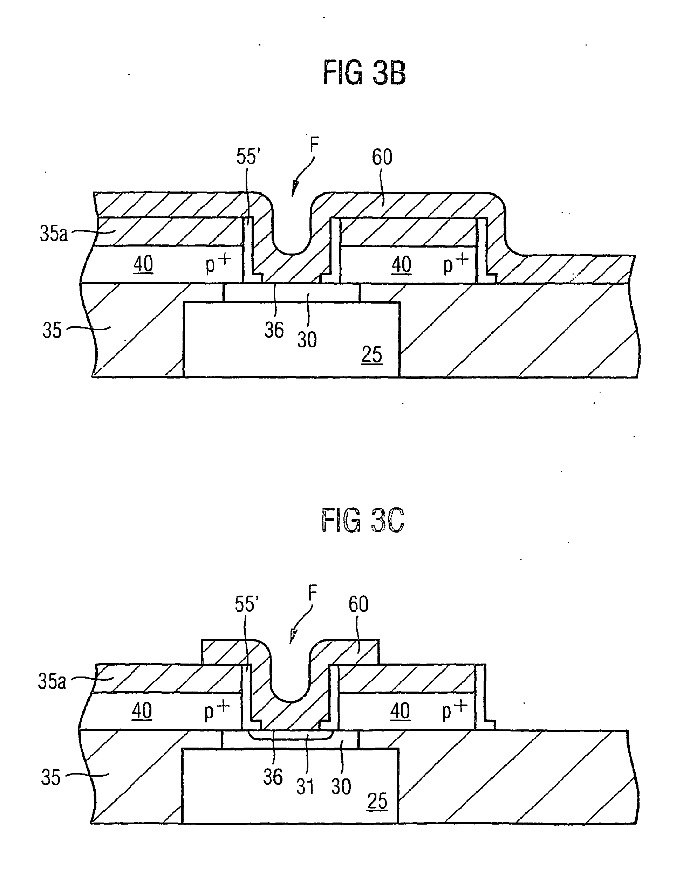

Fig. 3a-c sind schematische Darstellungen der Verfahrensschritte hinsichtlich des Emitterkontakts mit Oxidspacerisolation eines üblichen Verfahren zur Herstellung eines DPSA-Transistors, wobei im Unterschied zu Fig. 2 Bezugszeichen 55' diesen Einfachspacer aus Oxid bezeichnet. Bezugszeichen F bezeichnet das Emitterfenster in den Schichten 35 und 40.

Zur Herstellung des $n^+$-Emitterkontakts wird beim DPSA-Transistor nach der Bildung des Oxidspacers 55', der die Seitenwände des Emitterfensters F bedeckt auf dem aktiven $p^+$-Basisbereich eine $n^+$-dotierte (implantiert oder in-situ dotiert) $n^+$-Polysiliziumschicht 60 auf dem aktiven Transistorgebiet sowie auf den umliegenden Isolationsbereichen polykristallin aufgebracht.

Danach wird die $n^+$-Polysiliziumschicht 60 zur Bildung des endgültigen Emitterkontakts 60 mittels einer Fototechnik anisotrop strukturiert und mit einem Temperaturschritt der $n^+$-Dotierstoff z.B. 20 nm in das darunter liegende einkristalline Si-Material des Basisbereichs 30 eingetrieben (Fig. 3c). Auf diese Weise entsteht ein $n^+$-Emitter, der sich aus einem monokristallinen Anteil 31 und einem polykristallinen Anteil 60 zusammensetzt, zwischen denen sich eine sehr dünne natürliche Oxidschicht 36 befindet, die sich nach der Spacerätzung bildet.

Aufgabe der Erfindung ist es, ein verbessertes Verfahren zur Herstellung eines bipolaren Halbleiterbauelements, insbesondere eines Bipolartransistors, und ein entsprechendes bipolares Halbleiterbauelement anzugeben, welches noch weiter verbesserte Hochfrequenzeigenschaften zeigt.

Diese Aufgabe wird durch ein Verfahren zur Herstellung eines bipolaren Halbleiterbauelements, insbesondere eines Bipolartransistors, nach Anspruch 1 und ein entsprechendes bipolares Halbleiterbauelement nach Anspruch 6 gelöst.

Die der vorliegenden Erfindung zugrundliegende Idee besteht darin, eine selbstjustierte Gas- bzw. Vakuumisolation dadurch zu erzeugen, dass zunächst ein Spacer zwischen den Basis- und Emitteranschlussbereichen erzeugt wird, der nach Fertigstellung des Emitters selektiv zu den Emitter- und Basisanschlussbereichen wieder entfernt wird, so dass ein Spalt zwischen diesen Anschlussbereichen entsteht. Anschließend wird durch eine nicht vollständig konforme Abscheidung eines Dielektrikums der Spalt zwischen Emitter- und Basisanschlussbereich verschlossen und mit einer vorbestimmten Gasatmosphäre gefüllt bzw. evakuiert, aber nicht wieder mit einem Festkörperdielektrikum gefüllt.

Nicht nur die Hochfrequenzeigenschaften, sondern auch die Emitter-Basis-Degradation sollte durch solch einen Gas- bzw. Vakuumspacer deutlich verbessert sein, da kein Festköroerdielektrikum mehr vorhanden ist, in dem Traps erzeugt werden können. Damit sollten sich Transistoren realisieren lassen, die bei gleicher Dotierstoffverteilung bessere Langzeitstabilität aufweisen als Transistoren mit Dielektrikum. Die geringere Anfälligkeit gegen hot carrier stress könnte auch dazu genutzt werden, größere Dotierstoffkonzentrationen im Emitter-Basis-Bereich zu verwenden und damit den Basiswiderstand zu verringern. Dies ergäbe z. B. Transistoren mit höherer maximaler Oszillationsfrequenz, geringeren Gaterverzögerungszeiten und niedrigerem Rauschen.

Erfindungsgemässe Bauelemente im Vergleich zu heute gefertigten Bauelementen ohne wesentliche Änderung der Prozessführung herstellbar sind. Man benötigt lediglich eine modifizierte bzw. zusätzliche nasschemische Ätzung und eine nicht-konforme Abscheidung. Damit ergeben sich die verbesserten elektrischen Eigenschaften auch ohne nennenswerte Zusatzkosten.

Bevorzugte Weiterbildungen sind Gegenstand der jeweiligen Unteransprüche.

Gemäss einer bevorzugten Weiterbildung ist der erste Halbleiterbereich ein Basisbereich eines Bipolartransistors, unter dem zuvor ein zugehöriger Kollektorbereich des zweiten Leitungstyps gebildet wird, wobei der zweite Halbleiterbereich der zugehörige Emitterbereich ist.

Gemäss einer weiteren bevorzugten Weiterbildung sind der erste Isolationsbereich und der Seitenwandspacer (80) aus demselben Halbleitermaterial, insbesondere Siliziumoxid, und werden im selben Ätzprozess selektiv gegenüber dem ersten und zweiten Halbleiterbereich entfernt.

Gemäss einer weiteren bevorzugten Weiterbildung wird der zweite Isolationsbereich durch nicht-konformes Abscheiden und Planarisieren eines Isolationsmaterials gebildet.

Gemäss einer weiteren bevorzugten Weiterbildung ist das Halbleiterbauelement ein DPSA-Transistor.

Nachfolgend wird die Erfindung anhand von Ausführungsbeispielen unter Bezugnahme auf die Zeichnungen näher erläutert.

Es zeigen:

Fig. 1a-g     schematische Darstellungen der Verfahrensschritte einer erfindungsgemässen Ausführungsform des Verfahren zur Herstellung eines DPSA-Transistors;

Fig. 2     eine schematische Darstellung eines bekannten DPSA-Transiators; und

Fig. 3a-c     schematische Darstellungen der Verfahrensschritte hinsichtlich des Emitterkontakts mit Oxidspaceri- solation eines üblichen Verfahren zur Herstellung eines DPSA-Transistors.

In den Figuren gleiche Bezugszeichen bezeichnen gleiche oder gleich wirkende Elemente.

Die der vorliegenden Erfindung zugrundeliegenden Gedanken setzen bei Fig. 3c an. Die Emitter- und Basiselektroden 60, 40 des bekannten DPSA-Transistors bilden mit dem dazwischenliegenden Dielektrikum des Spacers 55' einen Kondensator, dessen Kapazität Csp die Emitter-Basis-Kapazität $C_{BE}$ des Transistors erhöht. Diese ist eine der wichtigsten Performance bestimmenden Größen eines Bipolartransistors. So gilt z.B. für die Transitfrequenz eines Bipolartransistors:

$$\frac{1}{2\pi f_t} = \tau_f + (R_c + R_E)C_{BC} + \frac{C_{BE} + C_{BC}}{I_c}U_T \qquad \text{(Gleichung 1)}$$

wobei

$f_T$     Transitfrequenz
$\tau_f$     Transitzeit
$R_C$     Kollektorwiderstand
$R_E$     Emitterwiderstand

$C_{BC}$     Basis-Kollektor-Kapazität
$C_{BE}$     Basis-Emitterkapazität
$I_C$       Kollektorstrom
$U_T$      Thermospannung

bezeichnen.

Man sieht, dass für kleine Kollektorströme die Transitfrequenz durch den Term proportional $1/I_C$ dominiert wird. Dieser wiederum wird durch die Basis-Emitter-Kapazität dominiert, weil typischerweise $C_{BE}$ um einige Faktoren größer als $C_{BC}$ ist. Für schnelle Transistoren, d.h. große Transitfrequenz muss daher $C_{BE}$ minimiert werden.

Die aktive Basis-Emitter-Kapazität im Emitter-Basis-Bereich wird durch die Skalierung der Bauteile stetig verkleinert, indem die Emitterfläche reduziert wird. Dafür ist gleichzeitig auch die Verringerung der Spacerschichtdicke nötig, damit der Spacer im immer kleineren Emitterfenster erzeugt werden kann ohne dieses vollständig zu füllen. Damit steigt aber die Spacerkapazität, die invers proportional zur Schichtdicke ist:

$$C_{sp} = \varepsilon_r \cdot \frac{A}{d_{sp}} \qquad\qquad\qquad \text{(Gleichung 2)}$$

wobei

$C_{sp}$     Spacerkapazität
$\varepsilon_r$      Dieelektrizitätskonstante des Spacermaterials
$A$       Fläche der Spacerkapazität (Emitter- zu Basispolysilizi- um,)
$d_{sp}$     Dicke der Spacerschicht

bezeichnen.

Bei heutigen Transistoren (aktive Emitterbreite z.B. typisch 200 nm und Spacerschichtdicke z.B. typisch 40 nm) beträgt das Verhältnis von aktiver Basis-Emitter-Kpazität $C_{BEa}$ zu Spacerkapazität $C_{sp}$ typisch ca. 8:1. Nimmt man z.B. eine Reduzierung der Emitterbreite und der Spacerschichtdicke jeweils um einen Faktor 2 an, beträgt das Verhältnis bereits 4:2. Die Spacerkapazität wird damit mit fortschreitender Bauteilskalierung zum Performance limitierenden Faktor.

Aus Gleichung 2 ist ersichtlich, dass die Spacerkapazität deutlich verringert werden könnte, wenn statt des Dielektrikums Siliziumoxid ($\varepsilon_r$=3.9) oder Siliziumnitrid ($\varepsilon_r$=7.5) ein Isolationsmaterial mit kleinerer Dielektrizitätskonstante verwendet werden könnte.

Ein weiterer Nachteil einer Emitter-Basis-Isolation aus Dielektrikum ist die Anfälligkeit gegenüber hot carrier stress (siehe z.B. A. Neugroschl, C. T. Sah, M. S. Caroll, Degradation of bipolar transistor current gain by hot holes during reverse emitter-base stress, IEEE Transactions on Electron Devices, Vol. 43, No. 8, pp. 1286-1290, 1996 ). Ladungsträger, die im Feld der Emitter-Basis-Raumladungszone beschleunigt werden, können durch Streuprozesse an den Spacer gelangen und dort Schäden (traps) erzeugen. Diese traps wirken anschließend als Rekombinationszentren für die Ladungsträger, was sich in einer unerwünschten Zunahme des Basisstroms und damit der Abnahme der Stromverstärkung des Transistors bemerkbar macht. Dieser Effekt wird in der Literatur auch als Emitter-Basis-Degradation bezeichnet.

Um die Emitter-Basis-Degradation möglichst zu vermeiden, darf die Feldstärke in der Emitter-Basis-Raumladungszone nicht zu groß werden. Dies begrenzt die in der Praxis maximal verwendbare Dotierstoffkonzentration am Emitter-Basis-Übergang auf Werte von kleiner etwa $5 \times 10^{18}$ cm$^{-3}$. Höhere Dotierstoffkonzentrationen wären aber wünschenswert um z.B. den Basiswiderstand des Transistors zu verringern.

Das der Erfindung zugrundeliegende Prinzip besteht darin, ein Dielektrikum in Form einer Gas- bzw. Vakuumisolation anstelle des bekannten Festkörperspacers zu verwenden, die eine wesentlich geringere Dielektrizitätskonstante aufweist. Der kleinstmögliche Wert wäre $\varepsilon_r$=1, d.h. eine Isolation mit Vakuum oder bestimmten Gasen (z.B. Luft). Eine solche Emitter-Basis-Isolation hat im Vergleich zu heute verwendeten Isolationen aus Oxid bzw. Nitrid eine um einen Faktor 3.9 bzw. 7.5 kleinere Spacerkapazität. Außerdem sollte die erwähnte Emitter-Basis-Degradation deutlich reduziert sein, weil kein Spacerdielektrikum vorhanden ist, in dem durch hot carrier stress Ladungsträgertraps erzeugt werden können.

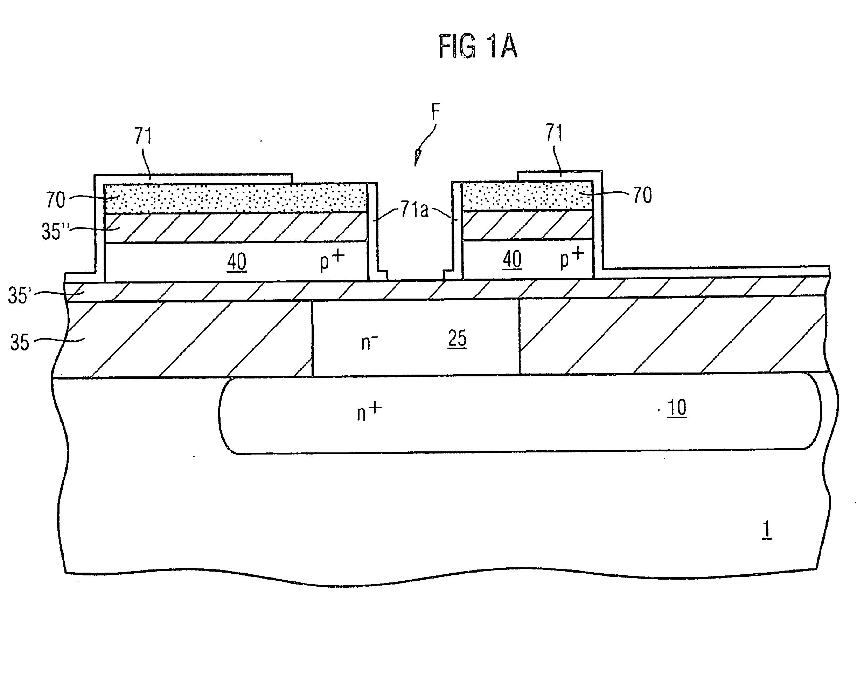

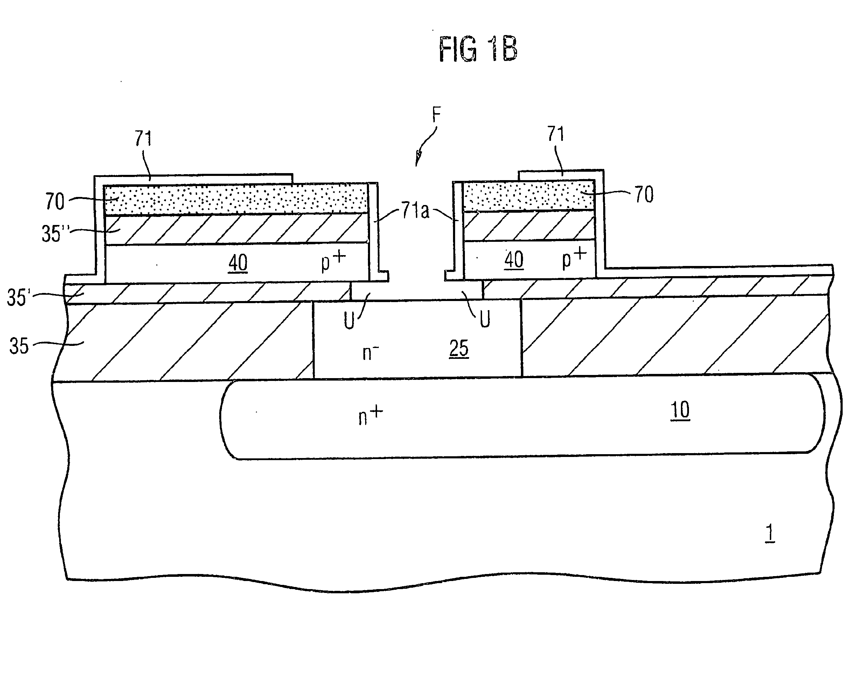

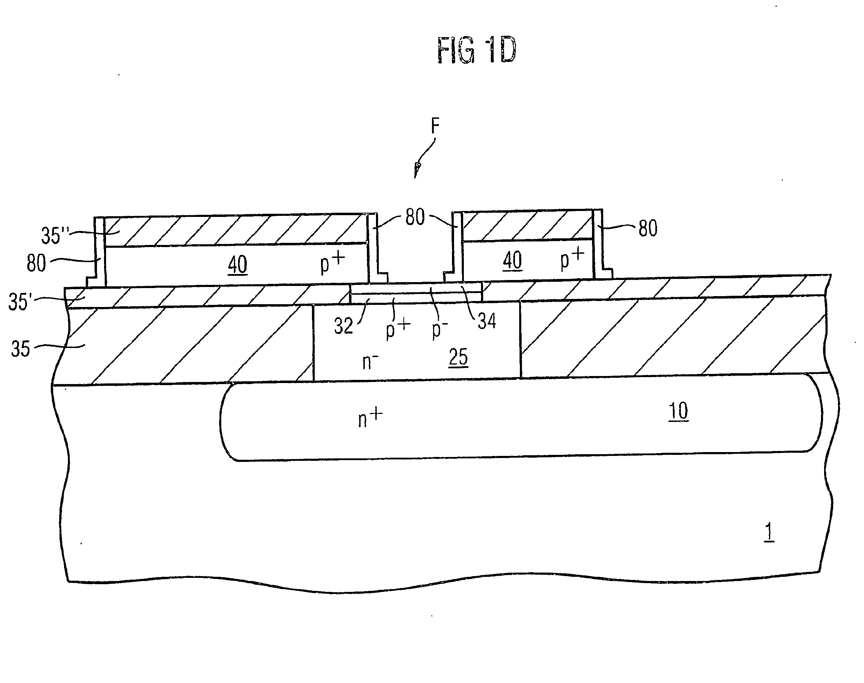

Fig. 1a-g sind schematische Darstellungen der Verfahrensschritte einer erfindungsgemässen Ausführungsform des Verfahren zur Herstellung eines DPSA-Transistors.

Ein bekanntes Herstellungsverfahren für den mittels selektiver SiGe-Basis-Epitaxie hergestellten DPSA-Transistor ist, wie oben erwähnt, z.B. in der DE 199 58 062 C2 ausführlich beschrieben. Es werden hier die zum Verständnis der geschilderten Ausführungsform wichtigsten Herstellungsschritte beginnend mit der selektiven Basisabscheidung erläutert.

Fig. 1a zeigt den Zustand des DPSA-Transistors vor der Integration der SiGe-Basis. Als Isolation wird hier z.B. die bekannte Shallow-Trench-Isolation verwendet. Bei dieser planaren Isolation ist der $n^-$-dotierte Kollektor 25 lateral durch die CVD-Oxidbereiche 35 isoliert. Der $n^-$-dotierte Kollektor 25 liegt auf dem niederohmigen, hoch As-dotierten Subkollektor 10. Der $n^-$-Kollektor 25 wird von einem 40-80 nm dicken CVD-Oxidschicht 35' abgedeckt. Auf der CVD-Oxidschicht 35' ist ein Stack bestehend aus dem $p^+$-Polysilizium-Basisanschluss 40, einer weiteren CVD-Oxidschicht 35 " und einer Nitridschicht 70 strukturiert. Die Seitenwände des oberhalb des $n^-$-dotierten Kollektors 25 gelegenen Emitterfensters F werden von einem dünnen Nitridspacer 71a bedeckt. Die zur Herstellung dieses Spacers 71a verwendete Nitridschicht 71 dient gleichzeitig dazu, die ausserhalb des Emitterfensters F gelegenen Isolationsbereiche der CVD-Oxidschicht 35' vor der nachfolgenden Nassätzung zu schützen.

Mittels dieser Nassätzung wird, wie in Fig. lb gezeigt, die CVD-Oxidschicht 35' im Emitterfenster F selektiv zu dem umgebenden Nitridspacer 71a entfernt. Diese isotrope Ätzung wird solange durchgeführt, bis selbstjustiert ein $p^+$-Polysilizium-Überhang U von ca. 80 nm entstanden ist.

Die $p^+$-dotierte SiGe-Basis 32 und die niedrig dotierte Si-Kappe (n- oder p-) 34 werden in einem CVD-Reaktor mittels selektiver Epitaxie auf dem freiliegenden Siliziumbereich des $n^-$-Kollektors 25 abgeschieden, wie in Fig. 2c gezeigt.

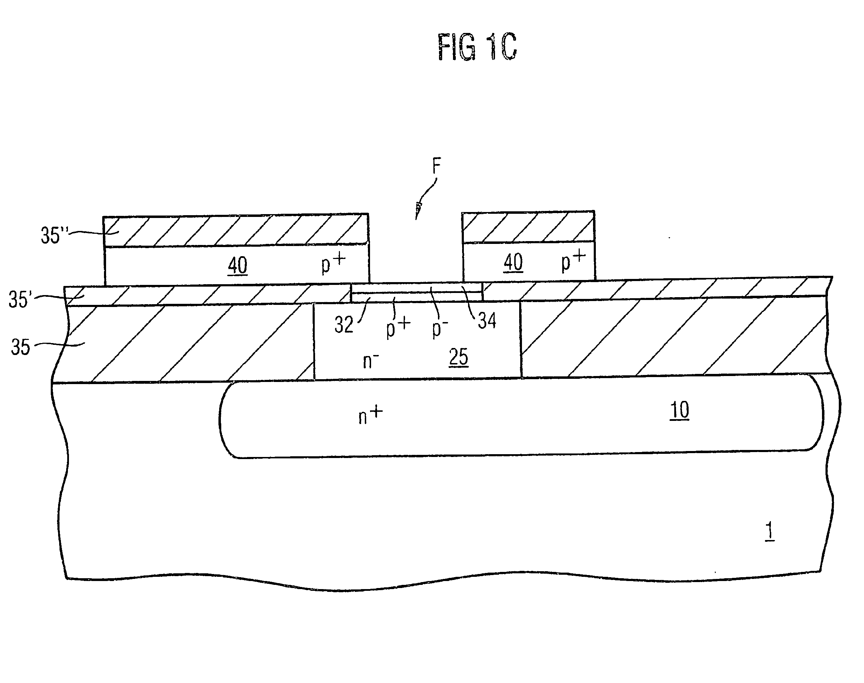

Bei der selektiven Epitaxie wird in der $p^+$-dotierten SiGe-Basis auch C ($1 \cdot 10^{18}$ cm$^{-3}$ - $1 \cdot 10^{20}$ cm$^{-3}$) gemäss Fig. 1c eingebaut, um die Diffusion der Boratome während der nachfolgenden Prozessschritte weitestgehend zu vermeiden. Die selektive Abscheidung der SiGe/Si-Schichten 32, 34 wird solange durchgeführt, bis ein niederohmiger Kontakt mit dem freiliegenden $p^+$-Polysilizium des Basisanschlusses erreicht ist. Danach werden die Nitridspacer 71a und die anderen Nitridhilfsschichten 70, 71 in Phosphorsäure selektiv zu Oxid und Si entfernt.

Danach werden gemäss Fig. ld Oxidspacer 80 an den Seitenwänden des Emitterfensters F angebracht, die später den $p^+$-Basisanschluss 40 von den $n^+$-dotierten Emitterbereichen isolieren bzw. die anderen Seitenkanten des $p^+$-Basisanschlusses 40 bei der Abscheidung des $n^+$-dotierten Emitterpolysiliziums schützen.

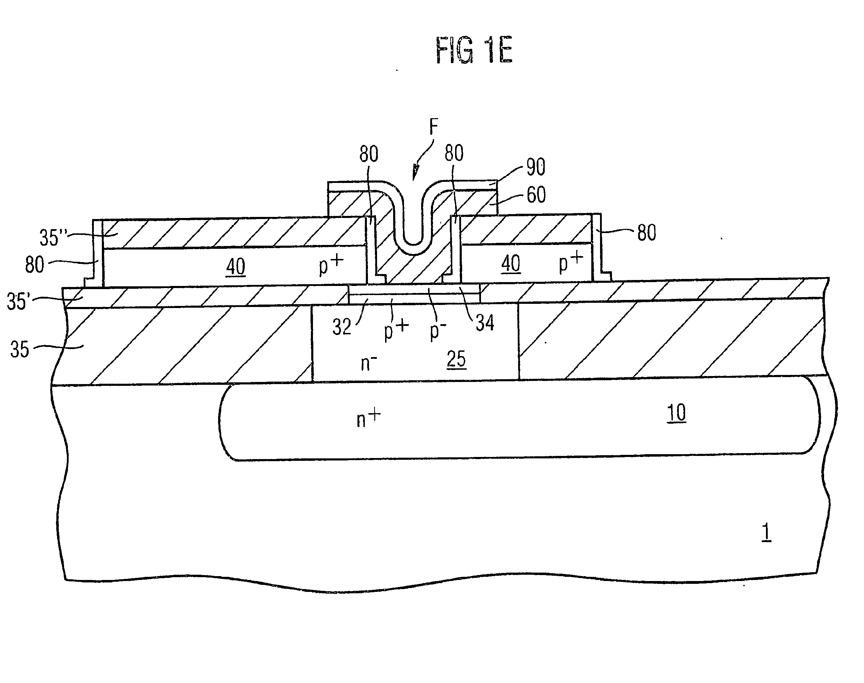

Dann wird gemäss Fig. 1e die $n^+$-dotierte polykristalline Emitterschicht 60 ganzflächig mittels abgeschieden. Nach dieser Abscheidung wird auf der $n^+$-dotierten Emitterschicht 60 noch ein dünne Nitridschicht 90 von etwa 20 nm aufgebracht und die resultierende Doppelschicht mittels einer Fototechnik anisotrop strukturiert. Dann wird mit einem Temperaturschritt der $n^+$-Dotierstoff z.B. 20 nm in das darunter liegende einkristalline Si-Material des Basiskappenbereichs 34 eingetrieben, um den in Fig. 2g nicht eingezeichneten monokristallinen Emitterbereich (vgl. Fig. 3c) zu bilden.

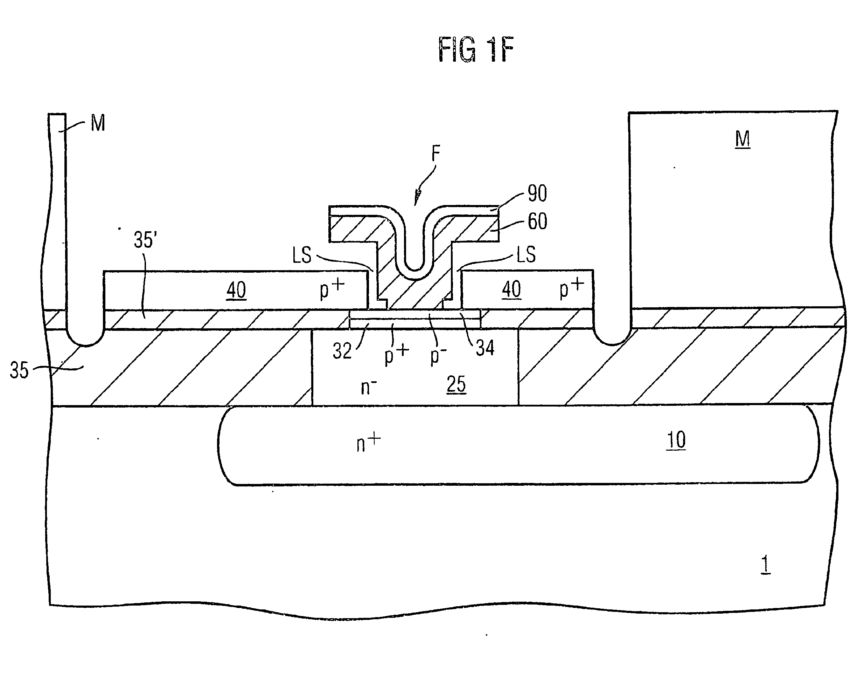

Danach wird gemäss Fig. 1f mittels einer Fototechnik eine Lackmaske M um das $p^+$-Polysilizium-Anschlussgebiet des DPSA-Transistors angebracht, die bei einem nachfolgenden Ätzprozess ein unerwünschtes Anätzen bestimmter Chipbereiche (z.B. der Isolationsgebiete oder anderer Bauteile) verhindert.

Nun werden die CVD-Oxidschicht 35 " und die Spacer 80 durch eine Ätzung selektiv zu Silizium entfernt, z. B. mit Flusssäure. Ist der Spacer 80 wie beim vorliegenden Beispiel aus dem gleichen Material wie die CVD-Oxidschicht 35 " über dem Basisanschlussbereich 40, so kann im Vergleich zum bekannten Prozess einfach die Ätzzeit der Ätzung entsprechend verlängert werden. Ist er aus einem anderen Material, muss nach Ätzung der CVD-Oxidschicht 35 " das Ätzmedium zur Ätzung des Spacers gewechselt werden. Der Transistor befindet sich nun in dem Zustand wie er in Abbildung 1f gezeigt ist. Zwischen dem Emitterbereich 60 und dem Basisanschlussbereich 40 ist nun der gewünschte Luftspalt LS entstanden.

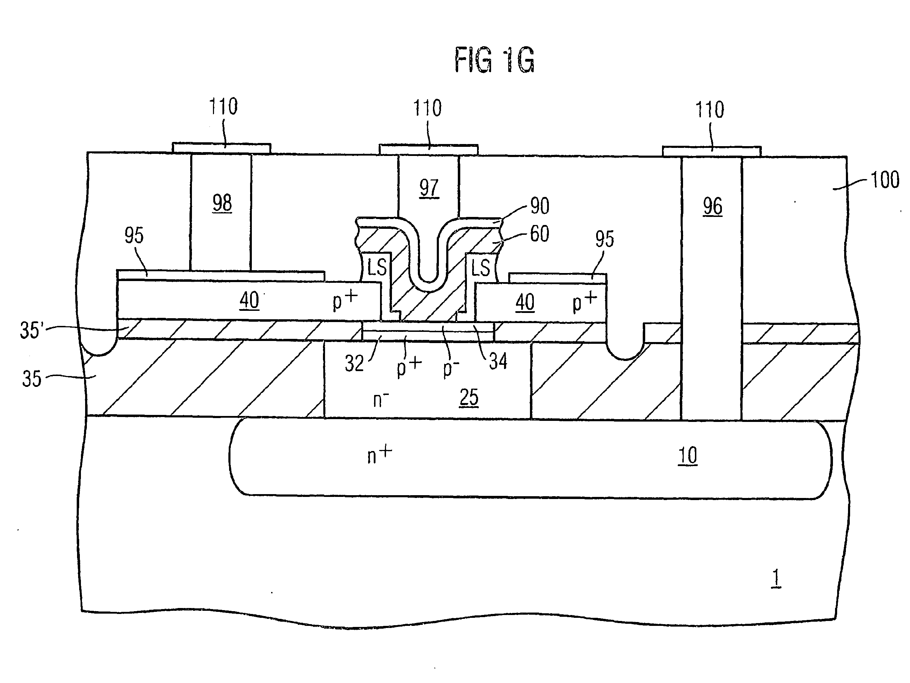

Anschliessend wird gemäss Fig. 1g die Maske M entfernt und auf den freiliegenden Bereichen des $p^+$-Polysiliziums des Basisanschlusses 40 eine Silizidschicht 95 erzeugt. Danach wird eine SiO$_2$-Schicht abgeschieden und durch chemisch-mechanisches Polieren planarisiert, so dass eine ca. 1500 nm dicke Zwischenoxidschicht 100 entsteht, die den gesamten Transistor bedeckt und den Spacer-Luftspalt LS verschließt, ohne ihn selbst wieder aufzufüllen. Dazu braucht man einen Abscheideprozess der nicht vollständig kantenbedeckend (konform) ist. Solche Prozesse sind bekannt. Typischerweise haben die Abscheideprozesse für die Dielektrika zwischen Transistor und erster Metallisierungsebene ohnehin diese Eigenschaften, so dass keine Umstellung der Prozessführung nötig ist. Luftspalte LS mit einigen 10 nm Durchmesser lassen sich problemlos verschließen ohne sie aufzufüllen.

Fig. 1g zeigt den fertig gestellten DPSA-Transistor, bei dem noch W-Kontakte 96, 97, 98 vorgesehen sind, mit denen Leitungen 110, z.B. aus AlCu, verbunden sind.

Das erfindungsgemässe Verfahren wurde anhand eines selbstjustierten Doppel-Polysilizium-Transistors mit Innenspacer beschrieben. Es ist prinzipiell jedoch für alle Bauteile mit dünnen Spacern geeignet.

Bezugszeichenliste

| 25 | Kollektorbereich |
| 30 | Basisbereich |

| 35,35a,35',35" | Oxidschicht |
|---|---|
| 40 | Basisanschlussbereich |
| 80 | Oxid-Seitenwandspacer |
| 60 | polykristalline Emitterschicht |
| F | Emitterfenster |
| 1 | Siliziumsubstrat |
| 10 | Subkollektorbereich |
| 70,71 | Nitridschicht |
| 71a | Nitrid-Seitenwandspacer |
| U | Überhang |
| 32 | Basisgrundschicht |
| 34 | Basiskappenschicht |
| 90 | Nitridmaske |
| M | Fotomaske |
| 100 | Zwischendielektrikum |
| 96,97,98 | Kontakte |
| 110 | Verdrahtung |
| 95 | Silizid |

**Patentansprüche**

1. Verfahren zur Herstellung eines bipolaren Halbleiterbauelements, insbesondere eines Bipolartransistors, mit den Schritten:

Vorsehen eines ersten Halbleiterbereichs (32, 34) eines ersten Leitungstyps (p) über einem Halbleitersubstrat (1);
Vorsehen eines Anschlussbereichs (40) des ersten Leitungstyps ($p^+$) über dem ersten Halbleiterbereich (32, 34);
Vorsehen eines ersten Isolationsbereichs (35") über dem Anschlussbereich (40);
Bilden eines Fensters (F) im ersten Isolationsbereich (35") und Anschlussbereich (40) zum zumindest teilweisen Freilegen des ersten Halbleiterbereichs (32, 34);
Vorsehen eines Seitenwandspacers (80) im Fenster (F) zum Isolieren des Anschlussbereichs (40);
Vorsehen eines zweiten Halbleiterbereichs (60) des zweiten Leitungstyps ($n^+$) in Fenster derart, dass er den Seitenwandspacer (80) und einen Teil des umgebenden ersten Isolationsbereichs (35'') überdeckt;
**gekennzeichnet durch** das
Entfernen des umgebenden ersten Isolationsbereichs (35") und des Seitenwandspacers (80) zum Bilden eines Spalts (LS) zwischen dem Anschlussbereich (40) und dem zweiten Halbleiterbereich (60); und das
Verschliessen des Spalts (LS) mit einem zweiten Isolationsbereich (100) unter gleichzeitigem Vorsehen einer Gas- oder Vakuumatmosphäre im verschlossenen Spalt (LS).

2. Verfahren nach Anspruch 1,
**dadurch gekennzeichnet,**
**dass** der erste Halbleiterbereich (32, 34) ein Basisbereich eines Bipolartransistors ist, unter dem zuvor ein zugehöriger Kollektorbereich (25) des zweiten Leitungstyps ($n^-$) gebildet wird, und der zweite Halbleiterbereich (60) der zugehörige Emitterbereich ist.

3. Verfahren nach Anspruch 1 oder 2,
**dadurch gekennzeichnet,**
**dass** der erste Isolationsbereich (35") und der Seitenwandspacer (80) aus demselben Material, insbesondere Siliziumoxid, sind und im selben Ätzprozess selektiv gegenüber dem ersten und zweiten Halbleiterbereich (40; 60) entfernt werden.

4. Verfahren nach Anspruch 1, 2 oder 3,
**dadurch gekennzeichnet,**
**dass** der zweite Isolationsbereich (100) durch nicht-konformes Abscheiden und Planarisieren eines Isolationsmaterials gebildet wird.

5. Verfahren nach einem der vorhergehenden Ansprüche,

**dadurch gekennzeichnet,**
**dass** das Halbleiterbauelement ein DPSA-Transistor ist.

**6.** Bipolares Halbleiterbauelement, insbesondere Bipolartransistor, mit:

einem ersten Halbleiterbereich (32, 34) eines ersten Leitungstyps (p) über einem Halbleitersubstrat (1);
einem Anschlussbereich (40) des ersten Leitungstyps ($p^+$) in Verbindung mit dem Halbleiterbereich (32, 34);
einem zumindest teilweise den esten Halbleiterbereich (32,34) freilegenden fenster (F) im Anschlussbereich (40);
einem zweiten Halbleiterbereich (60) des zweiten Leitungstyps ($n^+$) im Fenster (F) und einen Teil des umgebenden Anschlussbereichs (40) überdeckend ;
einen **gekennzeichnet durch** Spalt (LS) zwischen dem Anschlussbereich (40) und dem zweiten Halbleiterbereich (60); und
einen Isolationsbereich (100) zum Verschliessen des Spalts (LS) unter einer Gas- oder Vakuumatmosphäre.

**7.** Halbleiterbauelement nach Anspruch 6,
**dadurch gekennzeichnet,**
**dass** der erste Halbleiterbereich (32, 34) ein Basisbereich eines Bipolartransistors ist, unter dem zuvor ein zugehöriger Kollektorbereich (25) des zweiten Leitungstyps ($n^-$) gebildet ist, und der zweite Halbleiterbereich (60) der zugehörige Emitterbereich ist.

**8.** Halbleiterbauelement nach Anspruch 6 oder 7,
**dadurch gekennzeichnet,**
**dass** der zweite Isolationsbereich (100) durch ein nichtkonform abgeschiedenes und planarisiertes Isolationsmaterial gebildet ist.

**9.** Halbleiterbauelement nach einem der vorhergehenden Ansprüche 6 bis 8,
**dadurch gekennzeichnet,**
**dass** das Halbleiterbauelement ein DPSA-Transistor ist.

**Claims**

**1.** A method for manufacturing a bipolar semiconductor device, particularly a bipolar transistor, comprising the steps of:

Providing a first semiconductor region (32, 34) of a first conductivity type (p) on a semiconductor substrate (1);
providing a connecting region (40) of said first conductivity type ($p^+$) on the first semiconductor region (32, 34);
providing a first insulating region (35") on the connecting region (40);
forming a window (F) in the first insulating region (35") and connecting region (40) for at least partially exposing the first semiconductor region (32, 34);
providing a first sidewall spacer (80) in the window (F) for insulating the connecting region (40);
providing a second semiconductor region (60) of the second conductivity type ($n^+$) in the window such that it covers the sidewall spacer (80) and a part of the surrounding first insulating region (35");
**characterized by**
removing the surrounding first insulating region (35") and the sidewall spacer (80) for forming a gap (LS) between the connecting region (40) and the second semiconductor region (60); and
closing the gap (LS) with a second insulating region (100) while simultaneously providing a gas or vacuum atmosphere in the closed gap (LS).

**2.** The method of claim 1,
wherein the first semiconductor region (32, 34) is a base region of a bipolar transistor under which a corresponding collector region (25) of the second conductivity type ($n^-$) is formed before, and wherein the second conductivity region (60) is the corresponding emitter region.

**3.** The method of claim 1 or 2,
wherein the first insulating region (35") and the sidewall spacer (80) are made of the same material, particularly silicon oxide, and are selectively removed in the same etching process with respect to the first and second semiconductor region (40; 60).

**4.** The method of claim 1, 2 or 3,
wherein the second insulating region (100) is formed by non-conformal deposition and planarization of an insulating material.

**5.** The method according to one of the preceding claims,
wherein the semiconductor device is a DPSA transistor.

**6.** A bipolar semiconductor device, particularly a bipolar transistor, comprising:

a first semiconductor region (32, 34) of a first conductivity type (p) on a semiconductor substrate (1);
a connecting region (40) of the first conductivity type (p$^+$) in connection with the semiconductor region (32, 34);
a window (F) in the connecting region (40) which at least partially exposes the first semiconductor region (32, 34);
a second semiconductor region (60) of the second conductivity type (n$^+$) in the window (F) and partially covering the surrounding connecting region (40);
**characterized by**
a gap (LS) between the connecting region (40) and the second semiconductor region (60); and
an insulating region (100) for closing the gap (LS) under a gas or vacuum atmosphere.

**7.** The semiconductor device according to claim 6,
wherein the first semiconductor region (32, 34) is a base region of a bipolar transistor under which a corresponding collector region (25) of the second conductivity type (n$^-$) is formed before, and wherein the second semiconductor region (60) is the corresponding emitter region.

**8.** The semiconductor device according to claims 6 or 7,
wherein the second insulating region (100) is formed by a non-confomally deposited and planarized insulating material.

**9.** The semiconductor device according to one of claims 6 to 8,
wherein the semiconductor device is a DPSA transistor.

**Revendications**

**1.** Procédé de fabrication d'un composant à semi-conducteurs bipolaire, notamment d'un transistor bipolaire, avec les étapes:

- prévoir une première zone semi-conductrice (32, 34) d'un premier type de conduction (p) sur un substrat semi-conducteur (1) ;
- prévoir une zone de raccordement (40) du premier type de conduction (p+$^)$ sur la première zone semi-conductrice (32, 34) ;
- prévoir une première zone isolante (35") sur la zone de raccordement (40) ;
- former une fenêtre (F) dans la première zone isolante (35") et dans la zone de raccordement (40) pour dégager au moins en partie la première zone semi-conductrice (32, 34) ;
- prévoir un espaceur de paroi latérale (80) dans la fenêtre (F) pour isoler la zone de raccordement (40) ;
- prévoir une deuxième zone semi-conductrice (60) du deuxième type de conduction (n$^+$) dans la fenêtre de telle sorte qu'elle recouvre l'espaceur de paroi latérale (80) et une partie de la première zone isolante environnante (35") ;
**caractérisé par**:
- élimination de la première zone isolante environnante (35") et de l'espaceur de paroi latérale (80) pour former un espace (LS) entre la zone de raccordement (40) et la deuxième zone semi-conductrice (60) ; et
- fermeture de l'espace (LS) avec une deuxième zone isolante (100) tout en prévoyant une atmosphère gazeuse ou vide dans l'espace fermé (LS).

**2.** Procédé selon la revendication 1, **caractérisé en ce que** la première zone semi-conductrice (32, 34) est une zone de base d'un transistor bipolaire sous laquelle une zone de collecteur associée (25) du deuxième type de conduction (n$^-$) a été formée auparavant et **en ce que** la deuxième zone semi-conductrice (60) est la zone d'émetteur associée.

**3.** Procédé selon la revendication 1 ou 2, **caractérisé en ce que** la première zone isolante (35") et l'espaceur de paroi latérale (80) sont dans le même matériau, notamment de l'oxyde de silicium, et sont éliminés sélectivement par rapport à la première et à la deuxième zone semi-conductrice (40 ; 60) lors du même processus de gravure.

4. Procédé selon la revendication 1, 2 ou 3, **caractérisé en ce que** la deuxième zone isolante (100) est formée par dépôt non conforme et planarisation d'un matériau isolant.

5. Procédé selon l'une des revendications précédentes, **caractérisé en ce que** le composant à semi-conducteurs est un transistor DPSA.

6. Composant à semi-conducteurs bipolaire, notamment transistor bipolaire, avec :

- une première zone semi-conductrice (32, 34) d'un premier type de conduction (p) sur un substrat semi-conducteur (1) ;
- une zone de raccordement (40) du premier type de conduction ($p^+$) en liaison avec zone semi-conductrice (32, 34) ;
- une fenêtre (F) dans la zone de raccordement (40) de manière à dégager au moins en partie la première zone semi-conductrice (32, 34) ;
- une deuxième zone semi-conductrice (60) du deuxième type de conduction ($n^+$) dans la fenêtre (F) et recouvrant une partie de la zone de raccordement environnante (40) ;
**caractérisé par** :
- un espace (LS) entre la zone de raccordement (40) et la deuxième zone semi-conductrice (60) ; et
- une zone isolante (100) pour fermer l'espace (LS) sous atmosphère gazeuse ou vide.

7. Composant à semi-conducteurs selon la revendication 6, **caractérisé en ce que** la première zone semi-conductrice (32, 34) est une zone de base d'un transistor bipolaire sous laquelle une zone de collecteur associée (25) du deuxième type de conduction ($n^-$) a été formée auparavant et **en ce que** la deuxième zone semi-conductrice (60) est la zone d'émetteur associée.

8. Composant à semi-conducteurs selon la revendication 6 ou 7, **caractérisé en ce que** la deuxième zone isolante (100) est formée par un matériau isolant déposé de manière non conforme et planarisé.

9. Composant à semi-conducteurs selon l'une des revendications précédentes 6 à 8, **caractérisé en ce que** le composant à semi-conducteurs est un transistor DPSA.

FIG 1A

FIG 1B

EP 1 611 615 B1

# FIG 1C

EP 1 611 615 B1

# FIG 1D

EP 1 611 615 B1

# FIG 1E

EP 1 611 615 B1

## FIG 1F

EP 1 611 615 B1

# FIG 1G

EP 1 611 615 B1

# FIG 2

35a
40
p+
55 60
n+
p+
40
45
n+
p
n+
n−
p+
n+
p+
15
35
30
25
10
15
20
20
1

# FIG 3A

35a
55'
F
40
p+
36
40
p+
30
p
n−
25
35

## FIG 3B

## FIG 3C

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20010053584 A
- DE 19958062 C2

**In der Beschreibung aufgeführte Nicht-Patentliteratur**

- **T.F. Meister et al.** *IEDM Technical Digest,* 1995, 739-741
- **T.H. Ning et al.** Self-Aligned Bipolar Transistor for High-Performance and Low-Power-Delay VLSI. *IEEE Transactions on Electron Devices,* 1981, vol. ED-28 (9), 1010-1013
- **A. Neugroschl ; C. T. Sah ; M. S. Caroll.** Degradation of bipolar transistor current gain by hot holes during reverse emitter-base stress. *IEEE Transactions on Electron Devices,* 1996, vol. 43 (8), 1286-1290